# EUROPEAN PATENT APPLICATION

(11) **EP 4 726 768 A2**
(43) Date of publication of application: **15.04.2026**
(21) Application number: 25207523.9
(22) Date of filing: 08.10.2025
(51) Int. Cl.: H01J 37/26, H01J 37/248, H01J 37/16, H01B 3/16, H01B 3/56

(54) **INSULATION GAS FOR HIGH VOLTAGE COMPONENT OF ELECTRON MICROSCOPES**

(30) Priority: 09.10.2024 US 202463705372 P
(71) Applicant: FEI COMPANY, Hillsboro, OR 97124 (US)
(72) Inventor: METHLOUTHI, Abderraouf, Eindhoven (NL); VAN ROOIJ, Corne, Helmond (NL)
(74) Representative: Boult Wade Tennant LLP

(57) **Abstract**

Provided herein is a charged particle system 200, comprising a charged particle source system comprising a high voltage component 202, 204, 206 housed within a high voltage component volume defined by the charged particle source system, wherein the charged particle source system is configured to generate a charged particle beam, wherein an insulation gas occupies the high voltage component volume, and wherein the insulation gas comprises a mixture of a trifluoro gas and at least one other gas selected from the group consisting of atmospheric air, oxygen (O2), carbon dioxide (CO2), and nitrogen (N2); a sample chamber 208 comprising a stage configured to support a sample; and a charged particle beam column 210 configured to direct the charged particle beam towards the sample. Further provided herein is a method of using an insulation gas in a high voltage component of an electron particle system.

## Description

### BACKGROUND

Fluorinated gases ("F-gases") are manmade greenhouse gases used in various products and their emissions contribute to climate warming. Sulfur hexafluoride (SF₆) is one such gas. SF₆ has been used as a gaseous dielectric (insulator) in high voltage equipment since the 1950s. It is now known that SF₆ is a potent greenhouse warming gas with one of the highest global warming potentials (GWP) known, 23,500 versus CO₂. Because of its high GWP, it is being phased out of all frivolous applications. Additionally, new regulations plan to ban SF₆ from further use and existing solutions represent high risk for safety and design/work conditions. Additionally, there is currently no known substitute for SF₆ in electron microscopy. Thus, for such systems in particular, it is important to find a substitute for SF₆. Accordingly, a need exists for the development of gases for use as high voltage insulators that are less potent greenhouse gases and efficient at functioning as a high voltage insulators in, for example, electron microscope systems.

### BRIEF SUMMARY

Provided herein is an electron particle system, comprising an electron source system comprising a high voltage component housed within a high voltage component volume defined by the electron source system, wherein the electron source system is configured to generate an electron beam, wherein an insulation gas occupies the high voltage component volume, and wherein the insulation gas comprises a mixture of trifluoroiodomethane (CF₃I) and at least one other gas selected from the group consisting of oxygen (O₂), carbon dioxide (CO₂), and nitrogen (N₂); a sample chamber comprising a stage configured to support a sample; and an electron beam column configured to direct the electron beam towards the sample.

Also provided herein is a charged particle system, comprising a charged particle source system comprising a high voltage component housed within a high voltage component volume defined by the charged particle source system, wherein the charged particle source system is configured to generate a charged particle beam, wherein an insulation gas occupies the high voltage component volume, and wherein the insulation gas comprises a mixture of a trifluoro gas and at least one other gas selected from the group consisting of atmospheric air, oxygen (O₂), carbon dioxide (CO₂), and nitrogen (N₂); a sample chamber comprising a stage configured to support a sample; and an electron beam column configured to direct the electron beam towards the sample.

Further provided herein is a method of using an insulation gas in a high voltage component of an electron particle system, comprising mixing trifluoroamine oxide (F₃NO) and at least one other gas selected from the group consisting of atmospheric air, oxygen (O₂), carbon dioxide (CO₂), and nitrogen (N₂) to make the insulation gas; injecting the insultation gas into a high voltage component volume, wherein the high voltage component volume is leak-free; and pressurizing the high voltage component volume before operating the electron particle system.

### BRIEF DESCRIPTION OF THE DRAWINGS

The foregoing aspects and others will be readily appreciated by the skilled artisan from the following description of illustrative embodiments when read in conjunction with the accompanying drawings.
FIG. 1 is a schematic diagram of an example charged particle system, according to some embodiments of the present disclosure.
FIG. 2 depicts a charged particle system featuring the high voltage (HV) components of the charged particle system (e.g., the HV supply, the HV cable, and the HV accelerator) wherein the insulation gas is contained as well as the sample stage and detector, according to embodiments of the present disclosure.
FIG. 3 depicts a flowchart for using an insulation gas in a high voltage component of an electron particle system, according to embodiments of the present disclosure.
FIG. 4 depicts a block diagram of an example computer system usable with systems and methods, according to embodiments of the present disclosure.

### DETAILED DESCRIPTION

Before the present disclosure is described in detail, it is to be understood that the terminology used herein is for purposes of describing particular examples and embodiments only and is not intended to be limiting.

In this detailed description and in the claims that follow, reference will be made to a number of terms that shall be defined to have the following meanings:

As used herein, the terms "optional" or "optionally" mean that the subsequently described feature or structure may or may not be present, or that the subsequently described event or circumstance may or may not occur, and that the description includes instances where a particular feature or structure is present and instances where the feature or structure is absent, or instances where the event or circumstance occurs and instances where it does not.

As used herein, "comprising" is synonymous with "including," "containing," or "characterized by," and is inclusive or open-ended and does not exclude additional, unrecited elements or method steps. As used herein, "consisting of" excludes any element, step, or ingredient not specified in the claim element. As used herein, "consisting essentially of" does not exclude materials or steps that do not materially affect the basic and novel characteristics of the claim. Any recitation herein of the term "comprising", particularly in a description of components of a composition, in a description of a method, or in a description of elements of a device, is understood to encompass those compositions, methods, or devices consisting essentially of and consisting of the recited components or elements, optionally in addition to other components or elements. The invention illustratively described herein suitably may be practiced in the absence of any element, elements, limitation, or limitations which is not specifically disclosed herein.

Where a range of values is provided, it is understood that each intervening value, to the tenth of the unit of the lower limit unless the context clearly dictates otherwise, between the upper and lower limits of that range is also specifically disclosed. Each smaller range between any stated value or intervening value in a stated range and any other stated or intervening value in that stated range is encompassed within the invention. The upper and lower limits of these smaller ranges may independently be included or excluded in the range, and each range where either, neither or both limits are included in the smaller ranges is also encompassed within the invention, subject to any specifically excluded limit in the stated range. Where the stated range includes one or both of the limits, ranges excluding either or both of those included limits are also included in the invention.

The terms "about" or "approximate" and the like are synonymous and are used to indicate that the value modified by the term has an understood range associated with it, where the range can be ± 20%, ± 15%, ± 10%, ± 5%, or ± 1 %. The terms "substantially" and the like are used to indicate that a value is close to a targeted value, where close can mean, for example, the value is within 80% of the targeted value, within 85% of the targeted value, within 90% of the targeted value, within 95% of the targeted value, or within 99% of the targeted value.

The compounds of the present disclosure may be useful in gaseous phase for electrical insulation and for arc quenching and current interruption equipment used in the transmission and distribution of electrical energy, in particular, high voltage components. Generally, gases of the present disclosure can be used for insulation and/or interruption purposes in high voltage charged particle systems. Though gas-insulated equipment is a major component of power transmission and distribution systems all over the world, no gas described herein has been used or envisioned previously for use in a high voltage charged particle system.

The properties of a dielectric gas that should be present for its use in high voltage equipment are many and may vary depending on the particular application of the gas and the charged particle system.

Intrinsic properties are those properties of a gas which are inherent in the physical atomic or molecular structure of the gas. These properties are independent of the application or the environment in which a gas is placed. One of the desirable properties of a gaseous dielectric is high dielectric strength (higher, for instance than air). The gas properties that are principally responsible for high dielectric strength are those that reduce the number of electrons which are present in an electrically stressed dielectric gas. To effect such a reduction in the electron number densities, as gas should: (i) be electronegative (remove electrons by attachment over as wide an energy range as possible); it should preferably exhibit increased electron attachment with increasing electron energy and gas temperature since electrons have a broad range of energies and the gas temperature in many applications is higher than ambient; (ii) have good electron slowing-down properties (slow electrons down so that they can be captured efficiently at lower energies and be prevented from generating more electrons by electron impact ionization); and (iii) have low ionization cross section and high ionization onset (prevent ionization by electron impact). Besides the above properties, there are a number of other basic properties which should be present for the complete characterization of the dielectric gas behavior and its performance in practice, e.g., secondary processes such as electron emission from surfaces by ion and photon impact; photoprocesses; absorption of photoionizing radiation (this is a controlling factor in discharge development in non-uniform fields); dissociation under electron impact decomposition; ion-molecule reactions; reactions with trace impurities; and reactions with surfaces.

The dielectric gas may also have the following chemical properties: high vapor pressure; high specific heat, high thermal conductivity for gas cooling; thermal stability over long periods of time for temperatures greater than 400° K; chemical stability and inertness with regard to conducting and insulating materials; non-flammable; toxicity acceptable for industrial exposure; and non-explosive. When used in mixtures, it should have appropriate thermodynamic properties for mixture uniformity, composition, and separation.

Extrinsic properties are those which describe how a gas may interact with its surroundings, or in response to external influences, such as electrical breakdown and discharges. To be used in electrical applications, a dielectric gas should: undergo no extensive decomposition; lead to no polymerization; form no carbon or other deposits; and be noncorrosive and non-reactive to metals, insulators, spacers, and seals. In addition, it should have: no byproduct with toxicity unacceptable for industrial applications; removable byproducts; and a high recombination rate for reforming itself, especially for arc interruption. Finally, the gas should be environmentally friendly, e.g., it should not contribute to global warming, should not deplete stratospheric ozone, and should not persist in the environment for long periods of time. Said differently, the gas should have a low greenhouse gas effect, or a low global warming gas potential relative to CO₂.

Specific properties of the gas under discharge and breakdown conditions may include: a high breakdown voltage under uniform and non-uniform electric fields; insensitivity to surface roughness or defects and freely moving conducting particles; good insulation properties under practical conditions; good insulator flashover characteristics; good heat transfer characteristics; good recovery (rate of voltage recovery) and self-healing; no adverse reactions with moisture and common impurities; and no adverse effects on equipment, especially on high voltage systems.

The present disclosure addresses the issue by providing working alternatives to SF₆ for the use as an insulator in charged particle systems (e.g., an electron particle system). The remaining portions of the description may reference a charged particle system or an electron particle system broadly and no example given herein is intended to be limiting. It will be well understood to a skilled artisan that the present gas compositions may be used with charged particle microscopes in general, such as a transmission electron microscope (TEM), a scanning transmission electron microscope (STEM), a scanning tunneling microscope (STM), a field-emission scanning electron microscope (FESEM), an ion beam source (e.g., focused ion beam (FIB)), a reflection electron microscopes (REM), a circuit editing microscope (CEM), or the like. Accordingly, the disclosure and claims are not to be considered limited to any particular example charged particle system discussed but can be utilized broadly with any number of electron microscopes that may exhibit some or all of the electrical or chemical characteristics of the discussed examples.

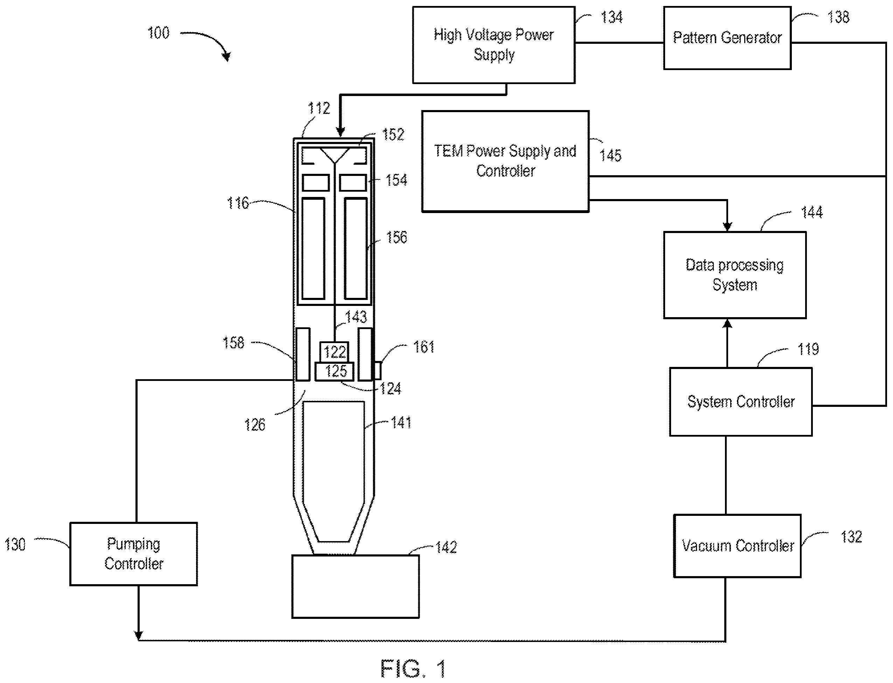

FIG. 1 is a schematic diagram of an example charged particle system 100 that includes a single beam, according to some embodiments. System 100 may be used with an insulation gas that occupies each of the high voltage component volume sections of the system 100. While an example of suitable hardware is provided below, the present disclosure is not limited to being implemented in any particular type of hardware. While a single beam system defines this example, the present disclosure can be used with any high voltage charged particle system that may use an insulation gas. Various embodiments of operation for a charged particle system as disclosed herein may be implemented using one or more algorithms performed by a computing system coupled to system 100.

In one non-limiting example, a TEM 112, along with power supply and control unit 145, are provided with the charged particle system 100. An electron beam 143 is emitted from a cathode 152 by applying voltage between cathode 152 and an anode 154. Electron beam 143 is focused to a fine spot by means of a condensing lens 156 and an objective lens 158. The operation of the condensing lens 156 and objective lens 158 and related components (not shown) is controlled by power supply and control unit 145.

Electron beam 143 can be focused onto sample 122, which is on stage 125 housed within the sample chamber 126. Sample 122 may be located on a surface of stage 125 or on sample holder 124, which extends from the surface of stage 125.

When the electrons in the electron beam strike sample 122, secondary electrons are emitted. In some embodiments, these secondary electrons may be detected by a secondary electron detector (not shown). In some embodiments, under the sample chamber 122 may be a projection system 141 and a viewing and camara chamber 142.

A door 161 is opened for inserting substrate 122 onto stage 124/125. The chamber 126 is evacuated with a turbomolecular and/or a mechanical pumping system 130 under the control of vacuum controller 132. The vacuum system provides within chamber 126 a vacuum of between approximately 1×10⁻⁷ Torr and 5×10⁻⁴ Torr. If an etch assisting gas, an etch retarding gas, or a deposition precursor gas is used, the chamber background pressure may rise, typically to about 1×10⁻⁵ Torr.

The high voltage power supply 134 provides an appropriate acceleration voltage to electrodes in focusing column 116 for energizing and focusing electron beam 143.

High voltage power supply 134 is connected to an electron source 138 as well as to appropriate electrodes in electron beam focusing components 152, 154, and 156 for forming an approximately 60 kV to 350 kV electron beam 143 and directing the same toward the sample 122. Beam blanking electrodes (not shown) within electron beam focusing column 116 may cause an electron beam 143 to impact onto blanking aperture (not shown) instead of sample 122 when a blanking controller (not shown) applies a blanking voltage to the blanking electrode. In some embodiments, the blanking controller (not shown) may control an electrostatic blanker/shutter as described above or a magnetic blanker/shutter.

The stage 125 may be a movable stage 125. The movable stage 125 may be configured for performing two horizontal movements, a vertical movement, a tilting movement, and/or a rotational movement, either within or with respect to the plane of the sample. The two horizontal movements may include selecting a field of view. The vertical movement may change a height of the sample and thus the depth of focus and/or the image resolution.

System controller 119 controls the operations of the various parts of the charged particle system 100. Through system controller 119, a user can cause a charged particle beam (e.g., an electron beam 143) to be scanned in a desired manner through commands entered into a conventional user interface (not shown). Alternatively, system controller 119 may control the charged particle system 100 in accordance with programmed instructions stored in a memory.

The charged particle system 100 may include a data processing system 144. The data-processing system 144 may include one or more processing units configured to carry out computer instructions of a program (e.g. machine readable and executable instructions). The processing unit(s) may be singular or plural. For example, the data processing system 144 may include at least one of CPU, GPU, DSP, APU, ASIC, ASIP or FPGA.

The data processing system 144 may include memory components, such as a data-storage component (not shown). The data-storage component (not shown) as well as the data-processing system 144 may include at least one of main memory (e.g. RAM), cache memory (e.g. SRAM) and/or secondary memory (e.g. HDD, SDD). The data processing system 144 may include volatile and/or non-volatile memory such an SDRAM, DRAM, SRAM, Flash Memory, MRAM, F-RAM, or P-RAM. The data processing system 144 may include internal communication interfaces (e.g. busses) configured to facilitate electronic data exchange between components of the data processing system 144, such as, the communication between the memory components and the processing components. The data processing system 144 may include external communication interfaces configured to facilitate electronic data exchange between the data-processing system and devices or networks external to the data-processing system. In the example of FIG. 1, the external communication interfaces may be configured for facilitating an electronic connection between the processing components of the data processing system 144 and components of the charged particle system 100, such as the TEM power supply and controller 145. Moreover, the external communication interfaces may be configured for establishing an electronic data exchange between the processing components of the data processing system 144 and the vacuum controller 132.

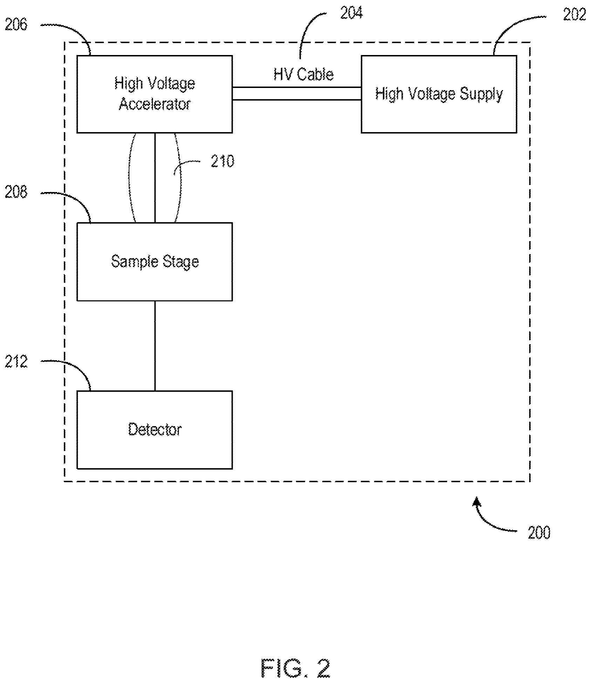

FIG. 2 shows the high voltage components of a general charged particle system 200 that require or contain an insulation gas. The charged particle system 200 is an example of the charged particle system 100 described herein. In one non-limiting embodiment, the charged particle system 200 is an electron particle system. More specifically, FIG. 2 represents a block diagram of the high voltage component (e.g., 202, 204, and 206) relative to the sample stage (208) and detector (212) of a charged particle system (200). In particular, the high voltage component (e.g., 202, 204, and 206) represents the volume of particular relevance to the use of the insulation gas described herein. FIG. 2 is a conceptual representation of components wherein the insulation gas is pressurized within a charged particle system (200). In certain embodiments, the insulation gas is pressurized inside the volume of the high voltage supply (202), the high voltage cable (204), and the high voltage accelerator (206).

In certain embodiments, the disclosure relates to an electron particle system comprising a high voltage component (e.g., 202, 204, and 206) comprising a high voltage supply 202 (e.g., the high voltage power supply 134), a high voltage cable 204 (e.g., the power supply cable 113), and a high voltage accelerator 206 (e.g., the ion source 114). In certain embodiments, the high voltage supply 202 which may refer to complex power conversion circuits that convert a lower voltage potential to a higher voltage potential. In certain embodiments, the high voltage supply 202 contains an insulation gas within a high voltage supply volume. In certain embodiments, the high voltage supply 202 is leak free. In certain embodiments, the electron particle system 200 further comprises a high voltage accelerator 206. In certain embodiments, a high voltage accelerator 206 may also be referred to as particle accelerator and may provide a component in the system 200 wherein the charged particles are accelerated to a high energy by a static voltage potential. In certain embodiments, the high voltage accelerator 206 contains an insulation gas within a high voltage accelerator volume. In certain embodiments, the high voltage accelerator 206 is leak free. In certain embodiments, the high voltage supply 202 is connected to the high voltage accelerator 206 by a high voltage cable 204. In certain embodiments, the high voltage cable 204 may refer to a cable that is used for electric power transmission at high voltage. In certain embodiments, the high voltage cable 204 contains an insulation gas within a high voltage cable volume. In certain embodiments, the high voltage cable 204 is substantially leak free. In one, non-limiting example, the charged particle system 200 is an electron particle system.

In certain embodiments according the present disclosure, an electron source system comprises a high voltage component, as described above, housed within a high voltage component volume defined by the electron source system. In certain embodiments, the electron source system is configured to generate an electron beam, wherein an insulation gas occupies the high voltage component volume. In certain embodiments, the insulation gas comprises a mixture of trifluoroiodomethane (CF₃I) and at least one other gas selected from the group consisting of oxygen (O₂), carbon dioxide (CO₂), and nitrogen (N₂). In certain embodiments, the electron source system comprises a sample chamber comprising a stage 208 configured to support a sample and an electron beam column 210 configured to direct the electron beam towards the sample. In certain embodiments, the electron source system further comprises a detector 212.

In certain embodiments, the insulation gas comprises 65% to 85% CF₃I. In terms of ranges, the insulation gas comprises from 60% to 70% CF₃I, from 65% to 75% CF₃I, from 70% to 80% CF₃I, from 75% to 85% CF₃I, or from 80% to 90% CF₃I. In terms of ranges, the insulation gas comprises from 65% to 70% CF₃I, from 70% to 75% CF₃I, from 75% to 80% CF₃I, or from 80% to 85% CF₃I.

In certain embodiments, the insulation gas comprises 70% CF₃I. In certain embodiments, the insulation gas comprises at least 60% CF₃I, at least 61% CF₃I, at least 62% CF₃I, at least 63% CF₃I, at least 64% CF₃I, at least 65% CF₃I, at least 66% CF₃I, at least 67% CF₃I, at least 68% CF₃I, at least 69% CF₃I, at least 70% CF₃I, at least 71% CF₃I, at least 72% CF₃I, at least 73% CF₃I, at least 74% CF₃I, at least 75% CF₃I, at least 76% CF₃I, at least 77% CF₃I, at least 78% CF₃I, at least 79% CF₃I, or at least 80% CF₃I.

In certain embodiments, the at least one other gas of the mixture is N₂ or CO₂.

In certain embodiments, the high voltage component (e.g., 202, 204, and 206) has a voltage of 30 to 300 kV. In terms of ranges, the high voltage component (e.g., 202, 204, and 206) has a voltage of at least 30 kV, at least 40 kV, at least 50 kV, at least 60 kV, at least 70 kV, at least 80 kV, at least 90 kV, at least 100 kV, at least 110 kV, at least 120 kV, at least 130 kV, at least 140 kV, at least 150 kV, at least 160 kV, at least 170 kV, at least 180 kV, at least 190 kV, at least 200 kV, at least 210 kV, at least 220 kV, at least 230 kV, at least 240 kV, at least 250 kV, at least 260 kV, at least 270 kV, at least 280 kV, at least 290 kV, at least 300 kV, at least 310 kV, at least 320 kV, at least 330 kV, at least 340 kV, or at least 350 kV.

In certain embodiments, the high voltage supply (202) has a volume of at least 200 L. In certain embodiments, the high voltage supply (202) may also refer to a high voltage generator. In certain embodiments, the high voltage supply (202) has a volume of at least 100 L, at least 110 L, at least 120 L, at least 130 L, at least 140 L, at least 150 L, at least 160 L, at least 170 L, at least 180 L, at least 190 L, at least 200 L, at least 210 L, at least 220 L, at least 230 L, at least 240 L, at least 250 L, at least 260 L, at least 270 L, at least 280 L, at least 290 L, or at least 300 L.

In one non-limiting example, the high voltage supply volume (e.g., 202) is 220 L for a 200 kV system. In another non-limiting example, the high voltage supply volume (e.g., 202) is 250 L for a 300 kV system.

In certain embodiments, the high voltage supply volume (e.g., 202) is pressurized to at least 4.0 bar. In certain embodiments, the high voltage supply volume (e.g., 202) is pressurized to at least 3.0 bar, at least 3.1 bar, at least 3.2 bar, at least 3.3 bar, at least 3.4 bar, at least 3.5 bar, at least 3.6 bar, at least 3.7 bar, at least 3.8 bar, at least 3.9 bar, at least 4.0 bar, at least 4.1 bar, at least 4.2 bar, at least 4.3 bar, at least 4.4 bar, at least 4.5 bar, at least 4.6 bar, at least 4.7 bar, at least 4.8 bar, at least 4.9 bar, or at least 5.0 bar.

In certain embodiments, a high voltage accelerator (206) may be an electron beam accelerator. In certain embodiments, an electron beam accelerator uses a cathode (i.e., a filament, an electron emitter) as the point source of electrons, wherein, the electrons may become a beam when they are accelerated across a voltage potential and reach high velocities. In one non-limiting example, the high voltage accelerator (206) is a filament used to generate an electron beam. In certain embodiments, the filament is a tungsten hairpin filament.

In certain embodiments, the high voltage accelerator (206) has a volume of at least 60 L. In certain embodiments, the high voltage accelerator (206) has a volume of at least 55 L, at least 56 L, at least 57 L, at least 58 L, at least 59 L, at least 60 L, at least 61 L, at least 62 L, at least 63 L, at least 64 L, at least 65 L, at least 66 L, at least 67 L, at least 68 L, at least 69 L, at least 70 L, at least 71 L, at least 72 L, at least 73 L, at least 74 L, at least 75 L, at least 76 L, at least 77 L, at least 78 L, at least 79 L, at least 80 L, at least 81 L, at least 82 L, at least 83 L, at least 84 L, or at least 85 L.

In certain embodiments, the high voltage accelerator volume (e.g., 206) is pressurized to at least 5.0 bar. In certain embodiments, the high voltage accelerator volume (e.g., 206) is at least 4.0 bar, at least 4.1 bar, at least 4.2 bar, at least 4.3 bar, at least 4.4 bar, at least 4.5 bar, at least 4.6 bar, at least 4.7 bar, at least 4.8 bar, at least 4.9 bar, at least 5.0 bar, at least 5.1 bar, at least 5.2 bar, at least 5.3 bar, at least 5.4 bar, at least 5.5 bar, at least 5.6 bar, at least 5.7 bar, at least 5.8 bar, at least 5.9 bar, or at least 6.0 bar.

In certain embodiments, the insulation gas prevents the formation of partial discharges inside the high voltage accelerator.

In certain embodiments, the high voltage component (e.g., 202, 204, and 206) has a high voltage stability limit of at most 50 mV. In certain embodiments, the high voltage component (e.g., 202, 204, and 206) has a high voltage stability limit of at most 45 mV, of at most 46 mV, of at most 47 mV, of at most 48 mV, of at most 49 mV, of at most 50 mV, of at most 51 mV, of at most 52 mV, of at most 53 mV, of at most 54 mV, or of at most 55 mV.

In certain embodiments, the high voltage cable (204) has a volume of less than 1.0 L. In certain embodiments, the high voltage cable (204) has a volume of less than 0.5 L, of less than 0.6 L, of less than 0.7 L, of less than 0.8 L, of less than 0.9 L, of less than 1.0 L, of less than 1.1 L, of less than 1.2 L, of less than 1.3 L, of less than 1.4 L, or of less than 1.5 L.

In another non-limiting example, the disclosure relates to an electron particle system (e.g., 200), comprising an electron source system comprising a high voltage component (e.g., 202, 204, and 206), wherein the high voltage component comprises a high voltage supply 202, a high voltage cable, 204, and a high voltage accelerator 206. In certain embodiments, the high voltage component defines a high voltage component volume defined by the electron source system and the high voltage supply 202, the high voltage cable 204, and the high voltage accelerator 206. In certain embodiments, the electron source system is configured to generate an electron beam. In certain embodiments, an insulation gas occupies the high voltage component volume. In certain embodiments, the insulation gas comprises a mixture of trifluoroamine oxide (F₃NO) and at least one other gas selected from the group consisting of oxygen (O₂), carbon dioxide (CO₂), and nitrogen (N₂); a sample chamber comprising a stage 208 configured to support a sample; and an electron beam column 210 configured to direct the electron beam towards the sample. In certain embodiments, the electron particle system further comprises a detector 212.

In certain embodiments, the insulation gas comprises 5% to 30% F₃NO. In terms of ranges, the insulation gas comprises from 1% to 5% F₃NO, from 2% to 6% F₃NO, from 3% to 7% F₃NO, from 4% to 8% F₃NO, from 5% to 10% F₃NO, from 6% to 11% F₃NO, from 7% to 12% F₃NO, from 8% to 13% F₃NO, from 9% to 14% F₃NO, from 10% to 15% F₃NO, from 11% to 16% F₃NO, from 12% to 17% F₃NO, from 13% to 18% F₃NO, from 14% to 19% F₃NO, from 15% to 20% F₃NO, from 16% to 21% F₃NO, from 17% to 22% F₃NO, from 18% to 23% F₃NO, from 19% to 24% F₃NO, from 20% to 25% F₃NO, from 21% to 26% F₃NO, from 22% to 27% F₃NO, from 23% to 28% F₃NO, from 24% to 29% F₃NO, from 25% to 30% F₃NO, from 26% to 31% F₃NO, from 27% to 32% F₃NO, from 28% to 33% F₃NO, from 29% to 34% F₃NO, or from 30% to 35% F₃NO.

In certain embodiments, the insulation gas comprises 20% F₃NO. In certain embodiments, the insulation gas comprises at least 15% F₃NO, at least 16% F₃NO, at least 17% F₃NO, at least 18% F₃NO, at least 19% F₃NO, at least 20% F₃NO, at least 21% F₃NO, at least 22% F₃NO, at least 23% F₃NO, at least 24% F₃NO, or at least 25% F₃NO.

### 2. Charged Particle System

In another non-limiting example, the disclosure relates to a charged particle system (200), comprising a charged particle source system comprising a high voltage component, wherein the high voltage component comprises a high voltage supply 202, a high voltage cable, 204, and a high voltage accelerator 206. In certain embodiments, the high voltage component defines a high voltage component volume defined by the charged particle source system and the high voltage supply 202, the high voltage cable 204, and the high voltage accelerator 206. In certain embodiments, the charged particle source system is configured to generate a charged particle beam. In certain embodiments, an insulation gas occupies the high voltage component volume. In certain embodiments, the insulation gas comprises a mixture of a trifluoro gas and at least one other gas selected from the group consisting of atmospheric air, oxygen (O₂), carbon dioxide (CO₂), and nitrogen (N₂); a sample chamber comprising a stage 208 configured to support a sample; and an electron beam column 210 configured to direct the electron beam towards the sample. In certain embodiments, the charged particle source system further comprises a detector 212.

In certain embodiments, the trifluoro gas is selected from the group consisting of trifluoroamine oxide (F₃NO), boron trifluoride (BF₃), thiazyl trifluoride (F₃NS), trifluoroiodomethane (CF₃I), and any combinations thereof. In certain embodiments, the trifluoro gas is preferably selected from trifluoroamine oxide (F₃NO) or trifluoroiodomethane (CF₃I). In certain embodiments, the trifluoro gas is CF₃I.

In certain embodiments, the insulation gas comprises 65% to 85% CF₃I. In terms of ranges, the insulation gas comprises from 60% to 70% CF₃I, from 65% to 75% CF₃I, from 70% to 80% CF₃I, from 75% to 85% CF₃I, or from 80% to 90% CF₃I. In terms of ranges, the insulation gas comprises from 65% to 70% CF₃I, from 70% to 75% CF₃I, from 75% to 80% CF₃I, or from 80% to 85% CF₃I.

In certain embodiments, the insulation gas comprises 70% CF₃I. In certain embodiments, the insulation gas comprises at least 60% CF₃I, at least 61% CF₃I, at least 62% CF₃I, at least 63% CF₃I, at least 64% CF₃I, at least 65% CF₃I, at least 66% CF₃I, at least 67% CF₃I, at least 68% CF₃I, at least 69% CF₃I, at least 70% CF₃I, at least 71% CF₃I, at least 72% CF₃I, at least 73% CF₃I, at least 74% CF₃I, at least 75% CF₃I, at least 76% CF₃I, at least 77% CF₃I, at least 78% CF₃I, at least 79% CF₃I, or at least 80% CF₃I.

In certain embodiments, the at least one other gas of the mixture is N₂ or CO₂.

In certain embodiments, the high voltage component (e.g., 202, 204, and 206) has a voltage of 30 to 300 kV at normal use. In terms of ranges, the high voltage component (e.g., 202, 204, and 206) has a voltage of at least 30 kV, at least 40 kV, at least 50 kV, at least 60 kV, at least 70 kV, at least 80 kV, at least 90 kV, at least 100 kV, at least 110 kV, at least 120 kV, at least 130 kV, at least 140 kV, at least 150 kV, at least 160 kV, at least 170 kV, at least 180 kV, at least 190 kV, at least 200 kV, at least 210 kV, at least 220 kV, at least 230 kV, at least 240 kV, at least 250 kV, at least 260 kV, at least 270 kV, at least 280 kV, at least 290 kV, at least 300 kV, at least 310 kV, at least 320 kV, at least 330 kV, at least 340 kV, or at least 350 kV.

In certain embodiments, the high voltage supply (202) has a volume of at least 200 L. In certain embodiments, the high voltage supply (202) has a volume of at least 100 L, at least 110 L, at least 120 L, at least 130 L, at least 140 L, at least 150 L, at least 160 L, at least 170 L, at least 180 L, at least 190 L, at least 200 L, at least 210 L, at least 220 L, at least 230 L, at least 240 L, at least 250 L, at least 260 L, at least 270 L, at least 280 L, at least 290 L, or at least 300 L.

In one non-limiting example, the high voltage supply volume (e.g., 202) is 220 L for a 200 kV system. In another non-limiting example, the high voltage supply volume (e.g., 202) is 250 L for a 300 kV system.

In certain embodiments, the high voltage supply (202) is pressurized to at least 4.0 bar. In certain embodiments, the high voltage supply volume (e.g., 202) is pressurized to at least 3.0 bar, at least 3.1 bar, at least 3.2 bar, at least 3.3 bar, at least 3.4 bar, at least 3.5 bar, at least 3.6 bar, at least 3.7 bar, at least 3.8 bar, at least 3.9 bar, at least 4.0 bar, at least 4.1 bar, at least 4.2 bar, at least 4.3 bar, at least 4.4 bar, at least 4.5 bar, at least 4.6 bar, at least 4.7 bar, at least 4.8 bar, at least 4.9 bar, or at least 5.0 bar.

In one non-limiting example, the high voltage accelerator (206) is a filament used to generate an electron beam.

In certain embodiments, the high voltage accelerator (206) has a volume of at least 60 L. In certain embodiments, the high voltage accelerator (206) has a volume of at least 55 L, at least 56 L, at least 57 L, at least 58 L, at least 59 L, at least 60 L, at least 61 L, at least 62 L, at least 63 L, at least 64 L, at least 65 L, at least 66 L, at least 67 L, at least 68 L, at least 69 L, at least 70 L, at least 71 L, at least 72 L, at least 73 L, at least 74 L, at least 75 L, at least 76 L, at least 77 L, at least 78 L, at least 79 L, at least 80 L, at least 81 L, at least 82 L, at least 83 L, at least 84 L, or at least 85 L.

In certain embodiments, the high voltage accelerator volume (e.g., 206) is pressurized to at least 5.0 bar. In certain embodiments, the high voltage accelerator volume (e.g., 206) is at least 4.0 bar, at least 4.1 bar, at least 4.2 bar, at least 4.3 bar, at least 4.4 bar, at least 4.5 bar, at least 4.6 bar, at least 4.7 bar, at least 4.8 bar, at least 4.9 bar, at least 5.0 bar, at least 5.1 bar, at least 5.2 bar, at least 5.3 bar, at least 5.4 bar, at least 5.5 bar, at least 5.6 bar, at least 5.7 bar, at least 5.8 bar, at least 5.9 bar, or at least 6.0 bar.

In certain embodiments, the insulation gas prevents the formation of partial discharges inside the high voltage accelerator.

In certain embodiments, the high voltage component (e.g., 202, 204, and 206) has a high voltage stability limit of at most 50 mV. In certain embodiments, the high voltage component (e.g., 202, 204, and 206) has a high voltage stability limit of at most 45 mV, of at most 46 mV, of at most 47 mV, of at most 48 mV, of at most 49 mV, of at most 50 mV, of at most 51 mV, of at most 52 mV, of at most 53 mV, of at most 54 mV, or of at most 55 mV.

In certain embodiments, the high voltage cable (204) has a volume of less than 1.0 L. In certain embodiments, the high voltage cable (204) has a volume of less than 0.5 L, of less than 0.6 L, of less than 0.7 L, of less than 0.8 L, of less than 0.9 L, of less than 1.0 L, of less than 1.1 L, of less than 1.2 L, of less than 1.3 L, of less than 1.4 L, or of less than 1.5 L.

In certain embodiments, the trifluoro gas is F₃NO. In certain embodiments, the insulation gas comprises 5% to 30% F₃NO. In terms of ranges, the insulation gas comprises from 1% to 5% F₃NO, from 2% to 6% F₃NO, from 3% to 7% F₃NO, from 4% to 8% F₃NO, from 5% to 10% F₃NO, from 6% to 11% F₃NO, from 7% to 12% F₃NO, from 8% to 13% F₃NO, from 9% to 14% F₃NO, from 10% to 15% F₃NO, from 11% to 16% F₃NO, from 12% to 17% F₃NO, from 13% to 18% F₃NO, from 14% to 19% F₃NO, from 15% to 20% F₃NO, from 16% to 21% F₃NO, from 17% to 22% F₃NO, from 18% to 23% F₃NO, from 19% to 24% F₃NO, from 20% to 25% F₃NO, from 21% to 26% F₃NO, from 22% to 27% F₃NO, from 23% to 28% F₃NO, from 24% to 29% F₃NO, from 25% to 30% F₃NO, from 26% to 31% F₃NO, from 27% to 32% F₃NO, from 28% to 33% F₃NO, from 29% to 34% F₃NO, or from 30% to 35% F₃NO.

In certain embodiments, the insulation gas comprises 20% F₃NO. In certain embodiments, the insulation gas comprises at least 15% F₃NO, at least 16% F₃NO, at least 17% F₃NO, at least 18% F₃NO, at least 19% F₃NO, at least 20% F₃NO, at least 21% F₃NO, at least 22% F₃NO, at least 23% F₃NO, at least 24% F₃NO, or at least 25% F₃NO.

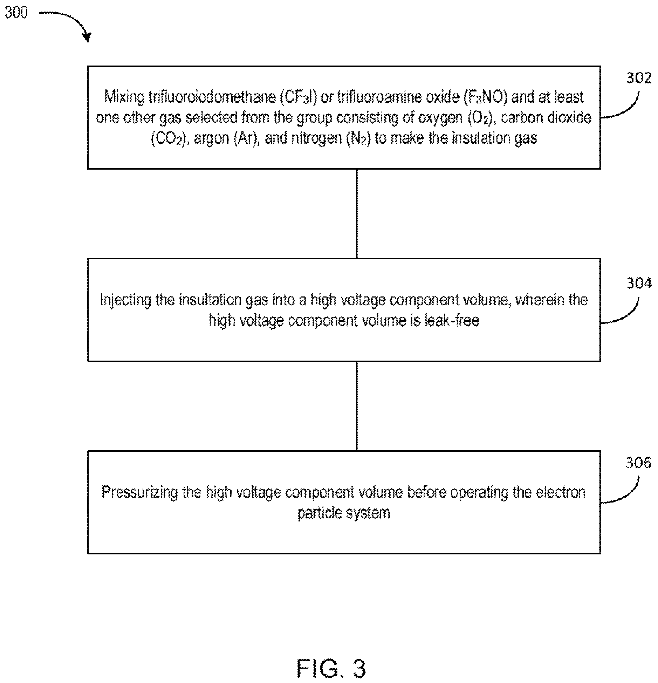

FIG. 3 illustrates an example flow 300 for insulating high voltage source systems using an insulation gas. In certain embodiments, the flow is applied to a system, such as the one described in FIGs. 1 or 2. In certain embodiments, the flow can be performed an operator. In some embodiments, the operator may be a subject, wherein the subject may be a human subject. In certain embodiments, the operator is a system for injecting a gas and pressurizing the gas. In certain embodiments, the steps of the flow are carried out and monitored by an operator as described above. In one non-limiting example, the flow 300 includes operation 302 where the operator mixes trifluoroiodomethane (CF₃I) and at least one other gas selected from the group consisting of atmospheric air, oxygen (O₂), carbon dioxide (CO₂), and nitrogen (N₂) to make the insulation gas. In certain embodiments, the mixing will be carried out by monitoring the flow of each gas into a vacuum sealed container prior to operation 304.

At operation 304, the operator injects the mixed insultation gas into a high voltage component volume, wherein the high voltage component volume is leak-free or substantially leak free. For instance, at the point of injection, the controller monitors the containment of the gas by operation 306.

At operation 306, the operator pressurizes the high voltage component volume before operating the electron particle system to ensure that there are no leaks in the pressurized system. In certain embodiments, a leak may have to be addressed prior to operating the high voltage component. In certain embodiments, once the high voltage component volume is pressurized, the high voltage component volume is insulated and operational

In certain embodiments, the insulation gas comprises 65% to 85% CF₃I. In terms of ranges, the insulation gas comprises from 60% to 70% CF₃I, from 65% to 75% CF₃I, from 70% to 80% CF₃I, from 75% to 85% CF₃I, or from 80% to 90% CF₃I. In terms of ranges, the insulation gas comprises from 65% to 70% CF₃I, from 70% to 75% CF₃I, from 75% to 80% CF₃I, or from 80% to 85% CF₃I.

In certain embodiments, the insulation gas comprises 70% CF₃I. In certain embodiments, the insulation gas comprises at least 60% CF₃I, at least 61% CF₃I, at least 62% CF₃I, at least 63% CF₃I, at least 64% CF₃I, at least 65% CF₃I, at least 66% CF₃I, at least 67% CF₃I, at least 68% CF₃I, at least 69% CF₃I, at least 70% CF₃I, at least 71% CF₃I, at least 72% CF₃I, at least 73% CF₃I, at least 74% CF₃I, at least 75% CF₃I, at least 76% CF₃I, at least 77% CF₃I, at least 78% CF₃I, at least 79% CF₃I, or at least 80% CF₃I.

In certain embodiments, the at least one other gas of the insulation gas is N₂ or CO₂.

In certain embodiments, the high voltage component (e.g., 202, 204, and 206) comprises a high voltage supply 202 and a high voltage accelerator 206 connected by a high voltage cable 204, as shown in FIG. 2.

In certain embodiments, the high voltage component (e.g., 202, 204, and 206) has a voltage of 30 to 300 kV. In terms of ranges, the high voltage component (e.g., 202, 204, and 206) has a voltage of at least 30 kV, at least 40 kV, at least 50 kV, at least 60 kV, at least 70 kV, at least 80 kV, at least 90 kV, at least 100 kV, at least 110 kV, at least 120 kV, at least 130 kV, at least 140 kV, at least 150 kV, at least 160 kV, at least 170 kV, at least 180 kV, at least 190 kV, at least 200 kV, at least 210 kV, at least 220 kV, at least 230 kV, at least 240 kV, at least 250 kV, at least 260 kV, at least 270 kV, at least 280 kV, at least 290 kV, at least 300 kV, at least 310 kV, at least 320 kV, at least 330 kV, at least 340 kV, or at least 350 kV.

In certain embodiments, the high voltage supply (202) has a volume of at least 200 L. In certain embodiments, the high voltage has supply (202) a volume of at least 100 L, at least 110 L, at least 120 L, at least 130 L, at least 140 L, at least 150 L, at least 160 L, at least 170 L, at least 180 L, at least 190 L, at least 200 L, at least 210 L, at least 220 L, at least 230 L, at least 240 L, at least 250 L, at least 260 L, at least 270 L, at least 280 L, at least 290 L, or at least 300 L.

In one non-limiting example, the high voltage supply volume (e.g., 202) is 220 L for a 200 kV system. In another non-limiting example, the high voltage supply volume (e.g., 202) is 250 L for a 300 kV system.

In certain embodiments, the high voltage supply volume (e.g., 202) is pressurized to at least 4.0 bar. In certain embodiments, the high voltage supply volume (e.g., 202) is pressurized to at least 3.0 bar, at least 3.1 bar, at least 3.2 bar, at least 3.3 bar, at least 3.4 bar, at least 3.5 bar, at least 3.6 bar, at least 3.7 bar, at least 3.8 bar, at least 3.9 bar, at least 4.0 bar, at least 4.1 bar, at least 4.2 bar, at least 4.3 bar, at least 4.4 bar, at least 4.5 bar, at least 4.6 bar, at least 4.7 bar, at least 4.8 bar, at least 4.9 bar, or at least 5.0 bar.

In one non-limiting example, the high voltage accelerator (206) is a filament used to generate an electron beam.

In certain embodiments, the high voltage accelerator (206) has a volume of at least 60 L. In certain embodiments, the high voltage accelerator (206) has a volume of at least 55 L, at least 56 L, at least 57 L, at least 58 L, at least 59 L, at least 60 L, at least 61 L, at least 62 L, at least 63 L, at least 64 L, at least 65 L, at least 66 L, at least 67 L, at least 68 L, at least 69 L, at least 70 L, at least 71 L, at least 72 L, at least 73 L, at least 74 L, at least 75 L, at least 76 L, at least 77 L, at least 78 L, at least 79 L, at least 80 L, at least 81 L, at least 82 L, at least 83 L, at least 84 L, or at least 85 L.

In certain embodiments, the high voltage accelerator volume (e.g., 206) is pressurized to at least 5.0 bar. In certain embodiments, the high voltage accelerator volume (e.g., 206) is at least 4.0 bar, at least 4.1 bar, at least 4.2 bar, at least 4.3 bar, at least 4.4 bar, at least 4.5 bar, at least 4.6 bar, at least 4.7 bar, at least 4.8 bar, at least 4.9 bar, at least 5.0 bar, at least 5.1 bar, at least 5.2 bar, at least 5.3 bar, at least 5.4 bar, at least 5.5 bar, at least 5.6 bar, at least 5.7 bar, at least 5.8 bar, at least 5.9 bar, or at least 6.0 bar.

In certain embodiments, the high voltage component (e.g., 202, 204, and 206) has a high voltage stability limit of at most 50 mV. In certain embodiments, the high voltage component (e.g., 202, 204, and 206) has a high voltage stability limit of at most 45 mV, of at most 46 mV, of at most 47 mV, of at most 48 mV, of at most 49 mV, of at most 50 mV, of at most 51 mV, of at most 52 mV, of at most 53 mV, of at most 54 mV, or of at most 55 mV.

In certain embodiments, the high voltage cable (204) has a volume of less than 1.0 L. In certain embodiments, the high voltage cable (204) has a volume of less than 0.5 L, of less than 0.6 L, of less than 0.7 L, of less than 0.8 L, of less than 0.9 L, of less than 1.0 L, of less than 1.1 L, of less than 1.2 L, of less than 1.3 L, of less than 1.4 L, or of less than 1.5 L.

In another application, FIG. 3 illustrates an example flow 300 where in operation 302 the operator mixes trifluoroamine oxide (F₃NO) and at least one other gas selected from the group consisting of atmospheric air, oxygen (O₂), carbon dioxide (CO₂), and nitrogen (N₂) to make the insulation gas. In certain embodiments, the mixing will be carried out by monitoring the flow of each gas into a vacuum sealed container prior to operation 304.

At operation 304, the operator injects the mixed insultation gas into a high voltage component volume, wherein the high voltage component volume is leak-free or substantially leak free. For instance, at the point of injection, the controller monitors the containment of the gas by operation 306.

At operation 306, the operator pressurizes the high voltage component volume before operating the electron particle system to ensure that there are no leaks in the pressurized system. In certain embodiments, a leak may have to be addressed prior to operating the high voltage component. In certain embodiments, once the high voltage component volume is pressurized, the high voltage component volume is insulated and operational.

In one example, the injecting step 304 takes place before the mixing step 302 wherein the high voltage component volume is filled with one of trifluoroiodomethane (CF₃I), trifluoramine oxide (F₃NO) or the like, before the additional of a gas selected from the group consisting of oxygen (O₂), carbon dioxide (CO₂), argon (Ar), and nitrogen (N₂) to make the insulation gas. In this example, the injecting step reaches a pressure with pure CF₃I, F₃NO, or the like, of at least 3.0 bar, 3.1 bar, 3.2 bar, 3.3 bar, 3.4 bar, 3.5 bar, 3.6 bar, 3.7 bar, 3.8 bar, 3.9 bar, or 4.0 bar before the addition of a gas selected from the group consisting of O₂, CO₂, Ar, and N₂ to reach a final pressure of at least 4.5 bar, 4.6 bar, 4.7 bar, 4.8 bar, 4.9 bar, 5.0 bar, 5.1 bar, 5.2 bar, 5.3 bar, 5.4 bar, or 5.5 bar.

In another example, the injecting step 304 takes place after the mixing step 302 wherein one of trifluoroiodomethane (CF₃I), trifluoramine oxide (F₃NO), or the like, is mixed with at least one other gas selected from the group consisting of oxygen (O₂), carbon dioxide (CO₂), argon (Ar), and nitrogen (N₂) to make the insulation gas, wherein the mixing ratio is 65:35, 66:34, 67:33, 68:32, 69:31, 70:30, 71:29, 72:28, 73:27, 74:26, or 75:25.

In certain embodiments, the insulation gas comprises 5% to 30% F₃NO. In terms of ranges, the insulation gas comprises from 1% to 5% F₃NO, from 2% to 6% F₃NO, from 3% to 7% F₃NO, from 4% to 8% F₃NO, from 5% to 10% F₃NO, from 6% to 11% F₃NO, from 7% to 12% F₃NO, from 8% to 13% F₃NO, from 9% to 14% F₃NO, from 10% to 15% F₃NO, from 11% to 16% F₃NO, from 12% to 17% F₃NO, from 13% to 18% F₃NO, from 14% to 19% F₃NO, from 15% to 20% F₃NO, from 16% to 21% F₃NO, from 17% to 22% F₃NO, from 18% to 23% F₃NO, from 19% to 24% F₃NO, from 20% to 25% F₃NO, from 21% to 26% F₃NO, from 22% to 27% F₃NO, from 23% to 28% F₃NO, from 24% to 29% F₃NO, from 25% to 30% F₃NO, from 26% to 31% F₃NO, from 27% to 32% F₃NO, from 28% to 33% F₃NO, from 29% to 34% F₃NO, or from 30% to 35% F₃NO.

In certain embodiments, the insulation gas comprises 20% F₃NO. In certain embodiments, the insulation gas comprises at least 15% F₃NO, at least 16% F₃NO, at least 17% F₃NO, at least 18% F₃NO, at least 19% F₃NO, at least 20% F₃NO, at least 21% F₃NO, at least 22% F₃NO, at least 23% F₃NO, at least 24% F₃NO, or at least 25% F₃NO.

In the preceding detailed description, numerous specific details have been set forth to provide a thorough understanding of claimed subject matter. However, it will be understood by those skilled in the art that claimed subject matter may be practiced without these specific details. In other instances, methods and apparatuses that would be known by one of ordinary skill have not been described in detail so as not to obscure claimed subject matter. Therefore, it is intended that claimed subject matter not be limited to the particular examples disclosed, but that such claimed subject matter may also include all aspects falling within the scope of appended claims, and equivalents thereof.

In certain embodiments, the disclosure relates to a non-transitory computer-readable medium embodying program code comprising instructions which, when executed by a processor, allow the use of a charged particle system comprising a charged particle source system comprising a high voltage component housed within a high voltage component volume defined by the charged particle source system, wherein the charged particle source system is configured to generate a charged particle beam, wherein an insulation gas occupies the high voltage component volume, and wherein the insulation gas comprises a mixture of a trifluoro gas and at least one other gas selected from the group consisting of atmospheric air, oxygen (O₂), carbon dioxide (CO₂), and nitrogen (N₂); a sample chamber comprising a stage configured to support a sample; and an electron beam column configured to direct the electron beam towards the sample. In certain embodiments, the trifluoro gas is selected from the group consisting of trifluoroamine oxide (F₃NO), boron trifluoride (BF₃), thiazyl trifluoride (F₃NS), trifluoroiodomethane (CF₃I), and any combinations thereof.

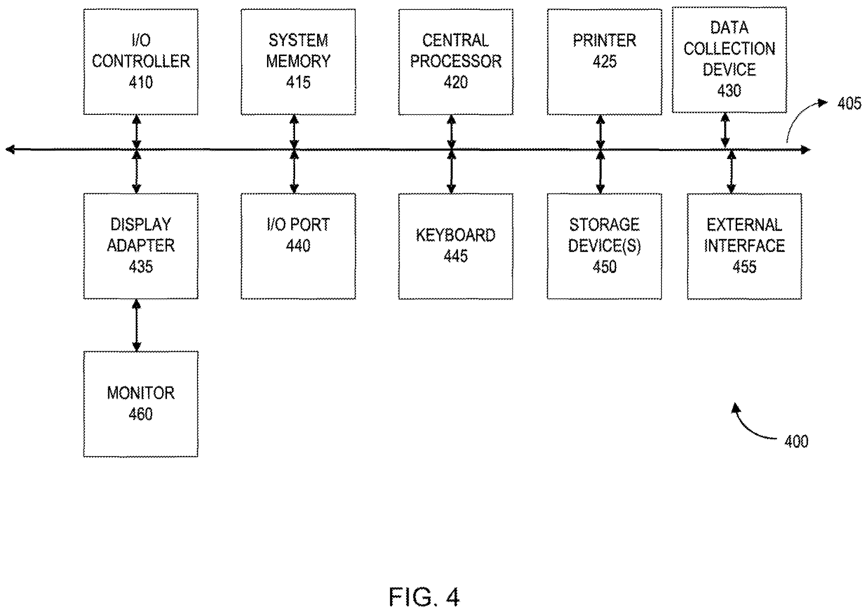

In certain embodiments, the computer-readable medium makes use of a computer system. In certain embodiments, a component of the computer system or the entirety of the computer system can be included in, integrated with, or interface with one or more components of the system as shown in FIG. 4. Any of the computer systems with applicable use in practicing the present disclosure may utilize any suitable number of subsystems. An example of such subsystems is shown in FIG. 4 in computer system 400. In some embodiments, a computer system includes a single computer apparatus, where the subsystems can be the components of the computer apparatus. In other embodiments, a computer system can include multiple computer apparatuses, each being a subsystem, with internal components. A computer system can include desktop and laptop computers, tablets, mobile phones and other mobile devices.

Any of the computer systems mentioned herein may utilize any suitable number of subsystems. An example of such subsystems is shown in FIG. 4 in computer system 400. In some embodiments, a computer system includes a single computer apparatus, where the subsystems can be the components of the computer apparatus. In other embodiments, a computer system can include multiple computer apparatuses, each being a subsystem, with internal components. A computer system can include desktop and laptop computers, tablets, mobile phones and other mobile devices.

The subsystems shown in FIG. 4 are interconnected via a system bus 405. Additional subsystems such as a printer 425, keyboard 445, storage device(s) 450, monitor 460 (e.g., a display screen, such as an LED), which is coupled to display adapter 435, and others are shown. Peripherals and input/output (I/O) devices, which couple to I/O controller 410, can be connected to the computer system by any number of means known in the art such as input/output (I/O) port 440 (e.g., USB, FireWire^{®}). For example, I/O port 440 or external interface 455 (e.g., Ethernet, Wi-Fi, etc.) can be used to connect computer system 400 to a wide area network such as the Internet, a mouse input device, or a scanner. The interconnection via system bus 405 allows the central processor 420 to communicate with each subsystem and to control the execution of a plurality of instructions from system memory 415 or the storage device(s) 450 (e.g., a fixed disk, such as a hard drive, or optical disk), as well as the exchange of information between subsystems. The system memory 415 and/or the storage device(s) 450 may embody a computer readable medium. Another subsystem is a data collection device 430, such as a camera, microphone, accelerometer, and the like. Any of the data mentioned herein can be output from one component to another component and can be output to the user.

A computer system can include a plurality of the same components or subsystems, e.g., connected together by external interface 455, by an internal interface, or via removable storage devices that can be connected and removed from one component to another component. In some embodiments, computer systems, subsystem, or apparatuses can communicate over a network. In such instances, one computer can be considered a client and another computer a server, where each can be part of a same computer system. A client and a server can each include multiple systems, subsystems, or components.

Aspects of embodiments can be implemented in the form of control logic using hardware circuitry (e.g., an application specific integrated circuit or field programmable gate array) and/or using computer software stored in a memory with a generally programmable processor in a modular or integrated manner, and thus a processor can include memory storing software instructions that configure hardware circuitry, as well as an FPGA with configuration instructions or an ASIC. As used herein, a processor can include a single-core processor, multicore processor on a same integrated chip, or multiple processing units on a single circuit board or networked, as well as dedicated hardware. Based on the disclosure and teachings provided herein, a person of ordinary skill in the art will know and appreciate other ways and/or methods to implement embodiments of the present disclosure using hardware and a combination of hardware and software.

Any of the software components or functions described in this application may be implemented as software code to be executed by a processor using any suitable computer language such as, for example, Java, C, C++, C#, Objective-C, Swift, or scripting language such as Perl or Python using, for example, conventional or object-oriented techniques. The software code may be stored as a series of instructions or commands on a computer readable medium for storage and/or transmission. A suitable non-transitory computer readable medium can include random access memory (RAM), a read only memory (ROM), a magnetic medium such as a hard-drive or a floppy disk, or an optical medium such as a compact disk (CD) or DVD (digital versatile disk) or Blu-ray disk, flash memory, and the like. The computer readable medium may be any combination of such devices. In addition, the order of operations may be re-arranged. A process can be terminated when its operations are completed but could have additional steps not included in a figure. A process may correspond to a method, a function, a procedure, a subroutine, a subprogram, etc. When a process corresponds to a function, its termination may correspond to a return of the function to the calling function or the main function.

Such programs may also be encoded and transmitted using carrier signals adapted for transmission via wired, optical, and/or wireless networks conforming to a variety of protocols, including the Internet. As such, a computer readable medium may be created using a data signal encoded with such programs. Computer readable media encoded with the program code may be packaged with a compatible device or provided separately from other devices (e.g., via Internet download). Any such computer readable medium may reside on or within a single computer product (e.g., a hard drive, a CD, or an entire computer system), and may be present on or within different computer products within a system or network. A computer system may include a monitor, printer, or other suitable display for providing any of the results mentioned herein to a user.

Any of the methods described herein may be totally or partially performed with a computer system including one or more processors, which can be configured to perform the steps. Any operations performed with a processor (e.g., aligning, determining, comparing, computing, calculating) may be performed in real-time. The term *"real-time"* may refer to computing operations or processes that are completed within a certain time constraint. The time constraint may be 1 minute, 1 hour, 1 day, or 7 days. Thus, embodiments can be directed to computer systems configured to perform the steps of any of the methods described herein, potentially with different components performing a respective step or a respective group of steps. Although presented as numbered steps, steps of methods herein can be performed at a same time or at different times or in a different order. Additionally, portions of these steps may be used with portions of other steps from other methods. Also, all or portions of a step may be optional. Additionally, any of the steps of any of the methods can be performed with modules, units, circuits, or other means of a system for performing these steps.

In the foregoing specification, embodiments of the disclosure have been described with reference to numerous specific details that can vary from implementation to implementation. The specification and drawings are, accordingly, to be regarded in an illustrative rather than a restrictive sense. The sole and exclusive indicator of the scope of the disclosure, and what is intended by the applicants to be the scope of the disclosure, is the literal and equivalent scope of the set of claims that issue from this application, in the specific form in which such claims issue, including any subsequent correction. The specific details of particular embodiments can be combined in any suitable manner without departing from the spirit and scope of embodiments of the disclosure.

Additionally, spatially relative terms, such as "bottom" or "top" and the like can be used to describe an element and/or feature's relationship to another element(s) and/or feature(s) as, for example, illustrated in the figures. It will be understood that the spatially relative terms are intended to encompass different orientations of the device in use and/or operation in addition to the orientation depicted in the figures. For example, if the device in the figures is turned over, elements described as a "bottom" surface can then be oriented "above" other elements or features. The device can be otherwise oriented (e.g., rotated 90 degrees or at other orientations) and the spatially relative descriptors used herein interpreted accordingly.

Terms "and," "or," and "an/or," as used herein, may include a variety of meanings that also is expected to depend at least in part upon the context in which such terms are used. Typically, "or" if used to associate a list, such as A, B, or C, is intended to mean A, B, and C, here used in the inclusive sense, as well as A, B, or C, here used in the exclusive sense. In addition, the term "one or more" as used herein may be used to describe any feature, structure, or characteristic in the singular or may be used to describe some combination of features, structures, or characteristics. However, it should be noted that this is merely an illustrative example and claimed subject matter is not limited to this example. Furthermore, the term "at least one of" if used to associate a list, such as A, B, or C, can be interpreted to mean any combination of A, B, and/or C, such as A, B, C, AB, AC, BC, AA, AAB, ABC, AABBCCC, etc.

Reference throughout this specification to "one example," "an example," "certain examples," or "exemplary implementation" means that a particular feature, structure, or characteristic described in connection with the feature and/or example may be included in at least one feature and/or example of claimed subject matter. Thus, the appearances of the phrase "in one example," "an example," "in certain examples," "in certain implementations," or other like phrases in various places throughout this specification are not necessarily all referring to the same feature, example, and/or limitation. Furthermore, the particular features, structures, or characteristics may be combined in one or more examples and/or features.

In certain embodiments, operations or processing may involve physical manipulation of physical quantities. Typically, although not necessarily, such quantities may take the form of electrical or magnetic signals capable of being stored, transferred, combined, compared, or otherwise manipulated. It has proven convenient at times, principally for reasons of common usage, to refer to such signals as bits, data, values, elements, symbols, characters, terms, numbers, numerals, or the like. It should be understood, however, that all of these or similar terms are to be associated with appropriate physical quantities and are merely convenient labels. Unless specifically stated otherwise, as apparent from the discussion herein, it is appreciated that throughout this specification discussions utilizing terms such as "processing," "computing," "calculating," "determining," or the like refer to actions or processes of a specific apparatus, such as a special purpose computer, special purpose computing apparatus or a similar special purpose electronic computing device. In the context of this specification, therefore, a special purpose computer or a similar special purpose electronic computing device is capable of manipulating or transforming signals, typically represented as physical electronic or magnetic quantities within memories, registers, or other information storage devices, transmission devices, or display devices of the special purpose computer or similar special purpose electronic computing device.

In the preceding detailed description, numerous specific details have been set forth to provide a thorough understanding of claimed subject matter. However, it will be understood by those skilled in the art that claimed subject matter may be practiced without these specific details. In other instances, methods and apparatuses that would be known by one of ordinary skill have not been described in detail so as not to obscure claimed subject matter. Therefore, it is intended that claimed subject matter not be limited to the particular examples disclosed, but that such claimed subject matter may also include all aspects falling within the scope of appended claims, and equivalents thereof.

Aspects of the disclosure and the invention may be further understood by reference to the following non-limiting clauses.

Exemplary clauses provided in accordance with the presently disclosed subject matter include, but are not limited to, the claims and the following embodiments:
Clause 1: An electron particle system, comprising an electron source system comprising a high voltage component housed within a high voltage component volume defined by the electron source system, wherein the electron source system is configured to generate an electron beam, wherein an insulation gas occupies the high voltage component volume, and wherein the insulation gas comprises a mixture of trifluoroiodomethane (CF₃I) and at least one other gas selected from the group consisting of oxygen (O₂), carbon dioxide (CO₂), and nitrogen (N₂); a sample chamber comprising a stage configured to support a sample; and an electron beam column configured to direct the electron beam towards the sample.
Clause 2: The electron particle system of clause 1, wherein the insulation gas comprises 65% to 85% CF₃I.
Clause 3: The electron particle system of clause 1 or clause 2, wherein the insulation gas comprises 70% CF₃I.
Clause 4: The electron particle system of any one of clauses 1 to 3, wherein the at least one other gas of the mixture is N₂ or CO₂.
Clause 5: The electron particle system of any one of clauses 1 to 4, wherein the high voltage component comprises a high voltage supply and a high voltage accelerator connected by a high voltage cable.
Clause 6: The electron particle system of any one of clauses 1 to 5, wherein the high voltage component has a voltage of 30 to 300 kV.
Clause 7: The electron particle system of any one of clauses 1 to 6, wherein the high voltage supply has a volume of at least 200 L.
Clause 8: The electron particle system of any one of clauses 1 to 7, wherein the high voltage supply volume is pressurized to at least 4.0 bar.
Clause 9: The electron particle system of any one of clauses 1 to 8, wherein the high voltage accelerator is a filament used to generate an electron beam.
Clause 10: The electron particle system of any one of clauses 1 to 9, wherein the high voltage accelerator has a volume of at least 60 L.
Clause 11: The electron particle system of any one of clauses 1 to 10, wherein the high voltage accelerator volume is pressurized to at least 5.0 bar.
Clause 12: The electron particle system of any one of clauses 1 to 11, wherein the insulation gas prevents the formation of partial discharges inside the high voltage accelerator.
Clause 13: The electron particle system of any one of clauses 1 to 12, wherein the high voltage component has a high voltage stability limit of at most 50 mV.
Clause 14: The electron particle system of any one of cluses 1 to 13, wherein the high voltage cable has a volume of less than 1 L.
Clause 15: A charged particle system, comprising a charged particle source system comprising a high voltage component housed within a high voltage component volume defined by the charged particle source system, wherein the charged particle source system is configured to generate a charged particle beam, wherein an insulation gas occupies the high voltage component volume, and wherein the insulation gas comprises a mixture of a trifluoro gas and at least one other gas selected from the group consisting of atmospheric air, oxygen (O₂), carbon dioxide (CO₂), and nitrogen (N₂); a sample chamber comprising a stage configured to support a sample; and an electron beam column configured to direct the electron beam towards the sample.
Clause 16: The charged particle system of clause 15, wherein the trifluoro gas is selected from the group consisting of trifluoroamine oxide (F₃NO), boron trifluoride (BF₃), thiazyl trifluoride (F₃NS), trifluoroiodomethane (CF₃I), and any combinations thereof.
Clause 17: The charged particle system of clause 15 or clause 16, wherein the trifluoro gas is CF₃I.
Clause 18: The charged particle system of any one of clauses 15 to 17, wherein the insulation gas comprises 65% to 85% CF₃I.
Clause 19: The charged particle system of any one of clauses 15 to 18, wherein the insulation gas comprises 70% CF₃I.
Clause 20: The charged particle system of any one of clauses 15 to 19, wherein the at least one other gas of the mixture is N₂ or CO₂.
Clause 21: The charged particle system of any one of clauses 15 to 20, wherein the high voltage component comprises a high voltage supply and a high voltage accelerator connected by a high voltage cable.
Clause 22: The charged particle system of any one of clauses 15 to 21, wherein the high voltage component has a voltage of 30 to 300 kV at normal use.
Clause 23: The charged particle system of any one of clauses 15 to 22, wherein the high voltage supply has a volume of at least 200 L.
Clause 24: The charged particle system of any one of clauses 15 to 23, wherein the high voltage supply is pressurized to at least 4.0 bar.
Clause 25: The charged particle system of any one of clauses 15 to 24, wherein the high voltage accelerator is a filament used to generate an electron beam.
Clause 26: The charged particle system of any one of clauses 15 to 25, wherein the high voltage accelerator has a volume of at least 60 L.
Clause 27: The charged particle system of any one of clauses 15 to 26, wherein the high voltage accelerator is pressurized to at least 5.0 bar.
Clause 28: The charged particle system of any one of clauses 15 to 27, wherein the insulation gas prevents the formation of partial discharges inside the high voltage accelerator.
Clause 29: The charged particle system of any one of clauses 15 to 28, wherein the high voltage component has a high voltage stability limit of at most 50 mV.
Clause 30: The charged particle system of any one of clauses 15 to 29, wherein the high voltage cable has a volume or less than 1 L.
Clause 31: A method of using an insulation gas in a high voltage component of an electron particle system, comprising mixing trifluoroamine oxide (F₃NO) and at least one other gas selected from the group consisting of atmospheric air, oxygen (O₂), carbon dioxide (CO₂), and nitrogen (N₂) to make the insulation gas; injecting the insultation gas into a high voltage component volume, wherein the high voltage component volume is leak-free; and pressurizing the high voltage component volume before operating the electron particle system.
Clause 32: The method of clause 31, wherein the insulation gas comprises 65% to 85% CF₃I.
Clause 33: The method of clause 31 or clause 32, wherein the insulation gas comprises 70% CF₃I.
Clause 34: The method of any one of clauses 31 to 33, wherein the at least one other gas of the insulation gas is N₂ or CO₂.
Clause 35: The method of any one of clauses 31 to 34, wherein the high voltage component comprises a high voltage supply and a high voltage accelerator connected by a high voltage cable.
Clause 36: The method of any one of clauses 31 to 35, wherein the high voltage component has a voltage of 30 to 300 kV at normal use.
Clause 37: The method of any one of embodiments 31 to 36, wherein the high voltage supply has a volume of at least 200 L.
Clause 38: The method of any one of clauses 31 to 37, wherein the high voltage supply is pressurized to at least 4.0 bar.
Clause 39: The method of any one of clauses 31 to 38, wherein the high voltage accelerator is a filament used to generate an electron beam.
Clause 40: The method of any one of clauses 31 to 39, wherein the high voltage accelerator has a volume of at least 60 L.
Clause 41: The method of any one of clauses 31 to 40, wherein the high voltage accelerator is pressurized to at least 5.0 bar.
Clause 42: The method of any one of clauses 31 to 41, wherein the high voltage component has a high voltage stability limit of at most 50 mV.
Clause 43: The method of any one of clauses 31 to 42, wherein the high voltage cable has a volume of less than 1 L.

### STATEMENTS REGARDING INCORPORATION BY REFERENCE AND VARIATIONS

All references throughout this application, for example patent documents, including issued or granted patents or equivalents and patent application publications, and non-patent literature documents or other source material are hereby incorporated by reference herein in their entireties, as though individually incorporated by reference.

All patents and publications mentioned in the specification are indicative of the levels of skill of those skilled in the art to which the invention pertains. References cited herein are incorporated by reference herein in their entirety to indicate the state of the art, in some cases as of their filing date, and it is intended that this information can be employed herein, if needed, to exclude (for example, to disclaim) specific embodiments that are in the prior art.

When a group of substituents is disclosed herein, it is understood that all individual members of those groups and all subgroups and classes that can be formed using the substituents are disclosed separately. When a Markush group or other grouping is used herein, all individual members of the group and all combinations and sub-combinations possible of the group are intended to be individually included in the disclosure. As used herein, "and/or" means that one, all, or any combination of items in a list separated by "and/or" are included in the list; for example, "1, 2 and/or 3" is equivalent to "1, 2, 3, 1 and 2, 1 and 3, 2 and 3, or 1, 2 and 3".

Every formulation or combination of components described or exemplified can be used to practice the invention, unless otherwise stated. Specific names of materials are intended to be exemplary, as it is known that one of ordinary skill in the art can name the same material differently. It will be appreciated that methods, device elements, starting materials, and synthetic methods other than those specifically exemplified can be employed in the practice of the invention without resort to undue experimentation. All art-known functional equivalents, of any such methods, device elements, starting materials, and synthetic methods are intended to be included in this invention. Whenever a range is given in the specification, for example, a temperature range, a time range, or a composition range, all intermediate ranges and subranges, as well as all individual values included in the ranges given are intended to be included in the disclosure.

The terms and expressions which have been employed are used as terms of description and not of limitation, and there is no intention in the use of such terms and expressions of excluding any equivalents of the features shown and described or portions thereof, but it is recognized that various modifications are possible within the scope of the invention claimed. Thus, it should be understood that although the present invention has been specifically disclosed by examples, embodiments, and optional features, modification and variation of the concepts herein disclosed may be resorted to by those skilled in the art, and that such modifications and variations are considered to be within the scope of this invention as defined by the appended claims.

## Claims

1. A charged particle system, comprising:
a charged particle source system comprising a high voltage component housed within a high voltage component volume defined by the charged particle source system, wherein the charged particle source system is configured to generate a charged particle beam, wherein an insulation gas occupies the high voltage component volume, and wherein the insulation gas comprises a mixture of a trifluoro gas and at least one other gas selected from the group consisting of atmospheric air, oxygen (O₂), carbon dioxide (CO₂), and nitrogen (N₂);
a sample chamber comprising a stage configured to support a sample; and
a charged particle beam column configured to direct the charged particle beam towards the sample.

2. The charged particle system of claim 1, wherein the trifluoro gas is selected from the group consisting of trifluoroamine oxide (F₃NO), boron trifluoride (BF₃), thiazyl trifluoride (F₃NS), trifluoroiodomethane (CF₃I), and any combinations thereof.

3. The charged particle system of claim 2, wherein the insulation gas comprises 65% to 85% CF₃I, and preferably 70% CF₃I.

4. The charged particle system of claim 1, claim 2 or claim 3, wherein the at least one other gas of the mixture is N₂ or CO₂.

5. The charged particle system of any preceding claim, wherein the high voltage component comprises a high voltage supply and a high voltage accelerator connected by a high voltage cable.

6. The charged particle system of any preceding claim, wherein the high voltage component has a voltage of 30 to 300 kV and/or a high voltage stability limit of at most 50mV.

7. The charged particle system of claim 5, wherein the high voltage supply has a volume of at least 200 L and is optionally pressurized to at least 4.0 bar.

8. The charged particle system of claim 5, wherein the charged particle beam is an electron beam, the high voltage accelerator is a filament used to generate the said electron beam, and wherein the charged particle beam column is an electron beam column configured to direct the electron beam towards the sample.

9. The charged particle system of claim 5, wherein the high voltage accelerator has a volume of at least 60 L and is optionally pressurized to at least 5.0 bar.

10. The charged particle system of claim 5, wherein the high voltage cable has a volume of less than 1 L.

11. A method of using an insulation gas in a high voltage component of an electron particle system, comprising:
mixing a trifluoro gas and at least one other gas selected from the group consisting of atmospheric air, oxygen (O₂), carbon dioxide (CO₂), and nitrogen (N₂) to make the insulation gas;
injecting the insultation gas into a volume of a high voltage component, wherein the high voltage component volume is leak-free; and
pressurizing the high voltage component volume before operating the electron particle system.

12. The method of claim 11, wherein the trifluoro gas is selected from the group consisting of trifluoroamine oxide (F₃NO), boron trifluoride (BF₃), thiazyl trifluoride (F₃NS), trifluoroiodomethane (CF₃I), and any combinations thereof.

13. The method of claim 12, wherein the insulation gas comprises 65% to 85% CF₃I, most preferably 70% CF₃I.

14. The method of claim 11, claim 12 or claim 13, wherein the at least one other gas of the insulation gas is N₂ or CO₂.

15. The method of any one of claims 11-14, further comprising:
applying a voltage of 30 to 300 kV to the high voltage component;
pressurizing a high voltage supply of the high voltage component to at least 4.0 bar; and/or
pressurizing a high voltage accelerator of the high voltage component to at least 5.0 bar.
